# EUROPEAN PATENT APPLICATION

(11) **EP 4 803 673 A1**
(43) Date of publication of application: **09.09.2026**
(21) Application number: 25189475.4
(22) Date of filing: 15.07.2025
(51) Int. Cl.: C30B 23/02, C30B 29/36

(54) **METHOD FOR GROWING SILICON CARBIDE CRYSTAL**

(30) Priority: 05.03.2025 CN 202510261021
(71) Applicant: Shenzhen Major Industry Investment Group & Tankeblue Semiconductor Co., Ltd., Shenzhen, Guangdong 518100 (CN); Tankeblue Semiconductor Co. Ltd, Beijing Daxing 102699 (CN); JIANGSU TANKEBLUE SEMICONDUCTOR CO., LTD, Xuzhou, Jiangsu 221000 (CN)
(72) Inventor: ZHAO, Ning, Guangdong, 518100 (CN); YANG, Jianhui, Guangdong, 518100 (CN); WANG, Ping, Guangdong, 518100 (CN); WANG, Bo, Beijing, 102699 (CN); PENG, Tonghua, Beijing, 102699 (CN); YANG, Jian, Beijing, 102699 (CN); ZENG, Jiang, Guangdong, 518100 (CN); PENG, Yong, Guangdong, 518100 (CN)
(74) Representative: Müller Schupfner & Partner Patent- und Rechtsanwaltspartnerschaft mbB (Muc)

(57) **Abstract**

The present disclosure provides a method for growing a silicon carbide crystal. During the growth process, the sublimed silicon carbide raw material passes through the porous silicon to reach the surface of the seed crystal. The abundant capillary channels in the porous silicon can filter carbon particles from the gas flow, preventing the carbon particles from adhering to the surface of the seed crystal and reducing the formation of carbon particle inclusions in the silicon carbide single crystal. The filtered carbon particles will react with the porous silicon to form SiC, and as the growth temperature increases, the SiC acts as a raw material and is decomposed into Si and C. Additionally, the porous silicon acts as a source of Si during the growth process, to balance the carbon-to-silicon ratio in the gas phase. This prevents excessive carbon from precipitating as carbon particles on the surface of the seed crystal, thereby avoiding the formation of carbon particle inclusions, as well as microtubes and dislocations evolved from the carbon particle inclusions.

## Description

### FIELD

The present disclosure relates to the technical field of semiconductor, in particular to a method for growing a silicon carbide crystal.

### BACKGROUND

Silicon carbide belongs to the third generation of semiconductor materials, and has the advantages such as wide bandgap, high thermal conductivity, high critical breakdown field strength, high electron saturation drift velocity. Therefore, it has great application prospects in the field of semiconductor manufacturing.

The industrial production of silicon carbides primarily adopts the physical vapor transport (PVT) method to grow silicon carbides, which requires harsh growth conditions. During the growth process, the raw materials gradually decompose. Due to the properties of Si, Si is lost rapidly, and the carbon to silicon ratio gradually increases, resulting in a carbon-rich state in the entire gas phase, which easily leads to the precipitation of carbon inclusion defects on the surface of the seed crystal. Moreover, the current commonly used filter layers are mostly graphite products, which will sublimate during the growth process, further making the carbon-rich in the gas phase and forming more carbon particle inclusions. In addition, as the growth process proceeds, the silicon carbide raw material becomes very brittle after graphitization and tends to form carbon particles that rise with the gas flow to the surface of seed crystals, further increasing the number of carbon inclusions. Carbon inclusions can also become the source of microtubes and dislocations, increasing the defect density in silicon carbide single crystals. These defects limit the improvement and advancement of the performance of the SiC devices and impede their industrial application and development.

Therefore, there is an urgent need to develop a method to effectively reduce the defects such as carbon inclusions, microtubes and dislocations in silicon carbide single crystals.

### SUMMARY

In view of this, a technical problem to be solved by the present disclosure is to provide a method for growing a silicon carbide crystal. The method for growing the silicon carbide crystal provided by the present disclosure can effectively reduce the defects such as carbon inclusions, microtubes, and dislocations in silicon carbide single crystals.

The present disclosure provides a method for growing a silicon carbide crystal comprising steps of:
A) putting silicon carbide raw material into a growth crucible,
B) placing porous silicon into the growth crucible with lower surface of the porous silicon attached to upper surface of the silicon carbide raw material, and
C) performing growing to obtain a silicon carbide crystal.

Preferably, the porous silicon has a purity of greater than 99.99%, a pore diameter of 100 to 300 µm, a porosity rate of 30% to 70%, and a thickness of 5 to 20 mm; and
the porous silicon has a size in horizontal direction smaller than the cross-sectional size of the growth crucible by d, 0 < d ≤ 0.5 mm.

Preferably, the porous silicon has a pore channel with a three-dimensional interlocking structure and the pore channel is in a direction parallel to an axis in a direction perpendicular to the growth crucible.

Preferably, the upper surface of the silicon carbide raw material is a flat surface and the lower surface of the porous silicon is a flat surface.

Preferably, the upper surface of the silicon carbide raw material is conical and the lower surface of the porous silicon is inwardly concaved into a conical shape with a size matching the conical shape formed by the upper surface of the silicon carbide raw material;
wherein an angle between the conical shape and the horizontal direction is θ, wherein 0 < θ≤ 30°.

Preferably, the pore channel of the porous silicon is arranged inclinedly around the axis in a direction perpendicular to the growth crucible, and an angle between the pore channel and the axis in a direction perpendicular to the growth crucible is γ, wherein 0 < γ ≤ 60°, wherein an inclined direction of the pore channel extends from the axis in a direction perpendicular to the growth crucible toward an inner wall of the growth crucible from top to bottom.

Preferably, the upper surface of the silicon carbide raw material is a flat surface and the lower surface of the porous silicon is a flat surface.

Preferably, the upper surface of the silicon carbide raw material is conical and the lower surface of the porous silicon is inwardly concaved into a conical shape with a size matching the conical shape formed by the upper surface of the silicon carbide raw material; and
wherein an angle between the conical shape and the horizontal direction is θ, wherein 0 < θ≤ 30°.

Preferably, an inner side of the growth crucible is cylindrical and the porous silicon is cylindrical.

Preferably, the growing is carried out at 2100°C to 2400°C for 100 to 200 h.

Compared to the prior art, the present disclosure provides a method for growing a silicon carbide crystal, comprising steps of: A) putting silicon carbide raw material into a growth crucible, B) placing porous silicon into the growth crucible with lower surface of the porous silicon attached to upper surface of the silicon carbide raw material, and C) performing growing to obtain a silicon carbide crystal. During the growth process, the sublimed silicon carbide raw material passes through the porous silicon to reach the surface of the seed crystal. The abundant capillary channels in the porous silicon can filter carbon particles from the gas flow, preventing the carbon particle from adhering to the surface of the seed crystal and reducing the formation of carbon particle inclusions in the silicon carbide single crystal. The filtered carbon particles will react with the porous silicon to form SiC, and as the growth temperature increases, the SiC acts as a raw material and is decomposed into Si and C. Additionally, the porous silicon acts as a source of Si during the growth process to balance the carbon-to-silicon ratio in the gas phase. This prevents excessive carbon from precipitating as carbon particles on the surface of the seed crystal, thereby avoiding the formation of carbon particle inclusions, as well as microtubes and dislocations evolved from the carbon particle inclusions.

### BRIEF DESCRIPTION OF DRAWINGS

FIG. 1 is a schematic diagram of raw material assembly for growing silicon carbide crystals provided in Example 1.
FIG. 2 is a schematic diagram of raw material assembly for growing silicon carbide crystals provided in Example 3.
FIG. 3 is a schematic diagram of raw material assembly for growing silicon carbide crystals provided in Example 2.
FIG. 4 is a schematic diagram of raw material assembly for growing silicon carbide crystals provided in Example 4.

### DETAILED DESCRIPTION

The present disclosure provides a method for growing a silicon carbide crystal, comprising steps of:
A) putting silicon carbide raw material into a growth crucible,
B) placing porous silicon into the growth crucible with lower surface of the porous silicon attached to upper surface of the silicon carbide raw material, and
C) performing growing to obtain a silicon carbide crystal.

In the present disclosure, firstly, a growth crucible is prepared for growing the silicon carbide crystal. In the present disclosure, there is no particular limitation on the growth crucible, preferably, a graphite crucible is used.

Then, a raw material is put into the growth crucible, wherein the raw material is silicon carbide raw material and the silicon carbide has a high purity.

Next, the porous silicon is cut so that it can fit the size of the inner wall of the crucible. Preferably, the porous silicon has a size in horizontal direction smaller than the cross-sectional size of the growth crucible by d, wherein 0 < d ≤ 0.5 mm. It may be 0.01, 0.05, 0.1, 0.15, 0.2, 0.25, 0.3, 0.35, 0.4, 0.45, or 0.5, or any value between 0 and 0.5 mm.

In some preferred embodiments of the present disclosure, the inner wall of the growth crucible is cylindrical, and the inner diameter of the growth crucible is D₁. Therefore, the porous silicon is cut into a cylindrical shape. The porous silicon has a diameter D₂, D₂=D₁-d.

In the present disclosure, the porous silicon has a purity of greater than 99.99%, a pore diameter of 100 to 300 µm, a porosity rate of 30% to 70%, and a thickness of 5 to 20 mm. The pore diameter of the porous silicon may be 100, 150, 200, 250 or 300, or any value between 100 and 300 µm. The porosity rate may be 30%, 40%, 50%, 60% or 70%, or any value between 30% and 70%. The thickness may be 5, 10, 15 or 20, or any value between 5 and 20 mm. In some preferred embodiments of the present disclosure, the porous silicon has a purity of greater than 99.99%, a pore diameter of 180 µm, a porosity rate of 50%, and a thickness of 10 mm.

In some specific embodiments of the present disclosure, the porous silicon has a pore channel with a three-dimensional interlocking structure and the pore channel is in a direction parallel to the axis in a direction perpendicular to the growth crucible.

When the direction of the pore channel of the porous silicon is parallel to the axis in a direction perpendicular to the growth crucible, the upper surface of the silicon carbide raw material is a flat surface and the lower surface of the porous silicon is a flat surface.

When the pore channel of the porous silicon is parallel to the axis in a direction perpendicular to the growth crucible, the upper surface of the silicon carbide raw material can further be conical and the lower surface of the porous silicon is inwardly concaved into a conical shape with a size matching the conical shape formed by the upper surface of the silicon carbide raw material. The angle between the conical shape and the horizontal direction is θ, wherein 0 < θ≤ 30°. It may be 1°, 5°, 10°, 15°, 20°, 25° or 30°, or any value between 0° and 30°. The above mentioned configuration of the porous silicon and silicon carbide raw material can solve the problem of serious corrosion on the edge of the porous silicon due to the fact that the raw material close to the side wall of the crucible will be sublimated preferentially, and the sublimated gas flow will flow along the wall of the crucible.

In some specific embodiments of the present disclosure, the pore channel of the porous silicon is arranged inclinedly around the axis in a direction perpendicular to the growth crucible, and an angle between the pore channel and the axis in a direction perpendicular to the growth crucible is γ, wherein 0 < γ ≤ 60°. It may be 1°, 5°, 10°, 15°, 20°, 25°, 30°, 35°, 40°, 45°, 50°, 55° or 60°, or any value between 0° and 60°. An inclined direction of the pore channel extends from the axis in a direction perpendicular to the growth crucible toward an inner wall of the growth crucible from top to bottom. The above mentioned configuration of the pore channel of the porous silicon can solve the problems that the raw materials close to the side wall of the crucible are preferentially sublimated, the gas flow also flows along the wall of the crucible, resulting in uneven raw material supply in the radial direction of the seed crystal (less raw material supply at the center and more raw material supply at the edge), resulting in a concave-convex growth interface, thereby leading to insufficient effective thickness of the crystal and the formation of internal stress in the crystal, and causing the crystal to crack due to excessive internal stress.

The inclined arrangement of the pore channel of the porous silicon allows the raw material close to the side wall of the crucible to be transported through the pore channel of the porous silicon to the center of the seed crystals, balancing the growth rate of the crystals in the radial direction.

When the pore channel of the porous silicon is arranged inclinedly around the axis in a direction perpendicular to the growth crucible, the upper surface of the silicon carbide raw material is a flat surface and the lower surface of the porous silicon is a flat surface.

When the pore channel of the porous silicon is arranged inclinedly around the axis in a direction perpendicular to the growth crucible, the upper surface of the silicon carbide raw material can further be conical and the lower surface of the porous silicon is inwardly concaved into a conical shape with a size matching the conical shape formed by the upper surface of the silicon carbide raw material; wherein an angle between the conical shape and the horizontal direction is θ, wherein 0 < θ≤ 30°. It may be 1°, 5°, 10°, 15°, 20°, 25° or 30°, or any value between 0° and 30°. The above mentioned configuration of the porous silicon and the silicon carbide raw material can further optimize the transportation uniformity of the raw materials and decrease carbon particle inclusions.

After the silicon carbide raw material and porous silicon are placed, a process of growing the silicon carbide crystal is carried out to obtain silicon carbide crystals.

The present disclosure has no special limitation on the conditions for growing the silicon carbide crystal. The conditions for growing the silicon carbide crystal by the PVT method, known to those skilled in the art, can be used.

During the growth of silicon carbide crystals, the ratio of Si and C elements in the silicon carbide raw material particles is 1:1. The method of the present disclosure can obtain silicon carbide single crystals with low carbon inclusions, microtubes and dislocation defects only by the same grow mode as that of normal crystals, which effectively improves the quality of the silicon carbide substrate.

During the growth process, the sublimed silicon carbide raw material passes through the porous silicon to reach the surface of the seed crystal. The abundant capillary channels in the porous silicon can filter carbon particles from the gas flow, preventing the carbon particle from adhering to the surface of the seed crystal and reducing the formation of carbon particle inclusions in the silicon carbide single crystal. The filtered carbon particles will react with the porous silicon to form SiC, and as the growth temperature increases, the SiC acts as a raw material and then is decomposed into Si and C. Additionally, the porous silicon acts as a source of Si during the growth process, to balance the carbon-to-silicon ratio in the gas phase. This prevents excessive carbon from precipitating as carbon particles on the surface of the seed crystal, thereby avoiding the formation of carbon particle inclusions, as well as microtubes and dislocations evolved from the carbon particle inclusions.

In order to further understand the present disclosure, the method for growing the silicon carbide crystal provided by the present disclosure will be described below in conjunction with examples. The protection scope of the present disclosure is not limited by the following examples.

### Example 1

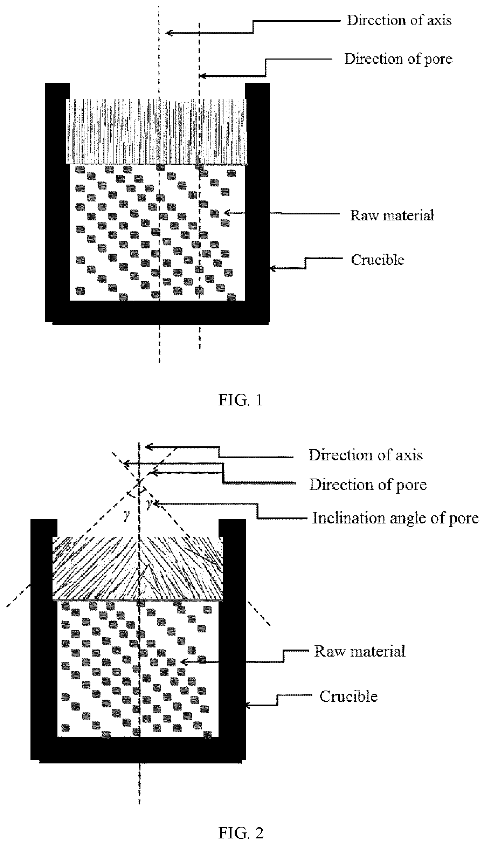

(1) A graphite crucible was selected for growth with an inner diameter of D₁. The high-purity silicon carbide raw material used for normal growth was loaded and the surface was flattened.
(2) A porous silicon with a purity greater than 99.99%, a pore diameter of 180 µm, a porosity rate of 50% and a thickness of 10 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material. The porous silicon had a pore channel with a three-dimensional interlocking structure and the pore channel was in a direction parallel to an axis in a direction perpendicular to the growth crucible, as shown in FIG. 1. FIG. 1 is a schematic diagram of raw material assembly for growing silicon carbide crystals provided in Example 1.
(4) Normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 1/cm².

### Example 2

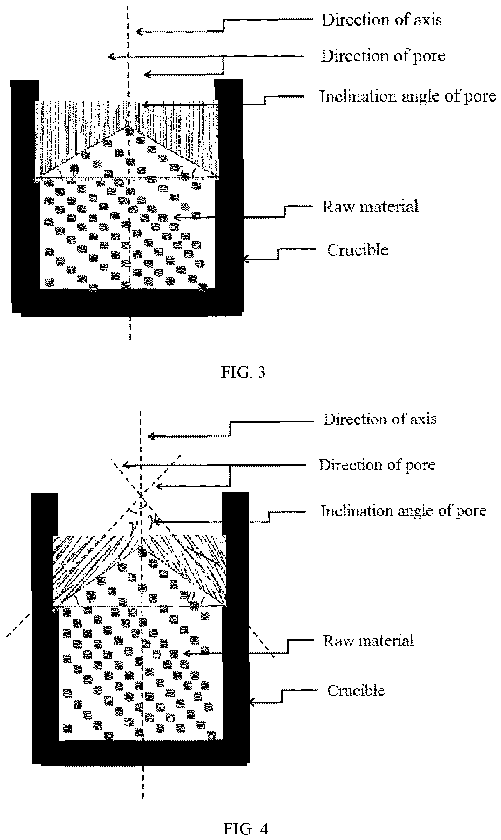

(1) A graphite crucible was selected for growth with an inner diameter of D₁. The high-purity silicon carbide raw material used for normal growth was loaded. The surface was a conical surface. The angle between the conical surface and the horizontal direction was θ=15°.
(2) A porous silicon with a purity greater than 99.99%, a pore diameter of 180 µm, a porosity rate of 50% and a thickness of 10 mm was selected and carefully cut into a cylinder with a diameter of D₂, D₂=D₁-d mm (d was about 0.3 mm). This cylinder was further processed into a cylinder with one side inwardly concaved into a cone. The angle between the concaved cone and the horizontal direction was 15°, so that the concaved part of the porous silicon can just fit with the conical silicon carbide raw material below.
(3) The porous silicon treated in step (2) was placed into the crucible loaded with silicon carbide raw material in step (1), and attached tightly to the raw material. The porous silicon had a pore channel with a three-dimensional interlocking structure and the pore channel was in a direction parallel to an axis in a direction perpendicular to the growth crucible, as shown in FIG. 3. FIG. 3 is a schematic diagram of raw material assembly for growing silicon carbide crystals provided in Example 2.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 0.6/cm².

### Example 3

(1) A graphite crucible was selected for growth with an inner diameter of D₁. The high-purity silicon carbide raw material used for normal growth was loaded and the surface was flattened.
(2) A porous silicon with a purity greater than 99.99%, a pore diameter of 180 µm, a porosity rate of 50% and a thickness of 10 mm was selected and carefully cut into a cylinder with a diameter of D₂, D₂=D₁-d mm (d was about 0.3 mm). It was ensured that the pores were oriented towards the axis of the cylindrical porous silicon in direction, and the angle of the pore channel and the axis in a direction perpendicular to the growth crucible was γ=30°.
(3) The porous silicon treated in step (2) was placed into the crucible loaded with silicon carbide raw material in step (1), and attached tightly to the raw material, as shown in FIG. 2. FIG. 2 is a schematic diagram of raw material assembly for growing silicon carbide crystals provided in Example 3.

Results: The prepared silicon carbide crystal was annealed, rounded, cut, ground, and polished, and then subjected to microscopic analysis and testing. Multiple tests showed that the defect density of carbon inclusion was about 0.6/cm².

### Example 4

(1) A graphite crucible was selected for growth with an inner diameter of D₁. The high-purity silicon carbide raw material used in normal growth was loaded. The surface was a conical surface. The angle between the conical surface and the horizontal direction was θ=15°.
(2) A porous silicon with a purity greater than 99.99%, a pore diameter of 180 µm, a porosity rate of 50% and a thickness of 10 mm was selected and carefully cut into a cylinder with a diameter of D₂, D₂=D₁-d mm (d was about 0.3 mm). It was ensured that the pores were oriented towards the axis of the cylindrical porous silicon in direction, and the angle of the pore channel and the axis in a direction perpendicular to the growth crucible was 30°. This cylinder was further processed into a cylinder with one side inwardly concaved into a cone. The angle between the concaved cone and the horizontal direction was θ=30°, so that the concaved part of the porous silicon can just fit with the conical silicon carbide raw material below.
(3) The prepared porous silicon was placed into the crucible loaded with silicon carbide raw material in step (1), and attached tightly to the raw material, as shown in FIG. 4. FIG. 4 is a schematic diagram of raw material assembly for growing silicon carbide crystals provided in Example 4.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 0.4/cm².

### Example 5

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 300 µm, a porosity rate of 70% and a thickness of 10 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material. The porous silicon had a pore channel with a three-dimensional interlocking structure and the pore channel was in a direction parallel to an axis in a direction perpendicular to the growth crucible.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 1.1/cm².

### Example 6

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 100 µm, a porosity rate of 30% and a thickness of 10 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material. The porous silicon had a pore channel with a three-dimensional interlocking structure and the pore channel was in a direction parallel to an axis in a direction perpendicular to the growth crucible.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 1/cm².

### Example 7

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 180 µm, a porosity rate of 50% and a thickness of 20 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material. The porous silicon had a pore channel with a three-dimensional interlocking structure and the pore channel was in a direction parallel to an axis in a direction perpendicular to the growth crucible.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 1/cm².

### Example 8

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 180 µm, a porosity rate of 50% and a thickness of 5 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material. The porous silicon had a pore channel with a three-dimensional interlocking structure and the pore channel was in a direction parallel to an axis in a direction perpendicular to the growth crucible.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 1.1/cm²_{∘}

### Comparative example 1

(1) A graphite crucible was selected for growth with an inner diameter of D₁. The high-purity silicon carbide raw material used in normal growth was loaded and the surface was flattened.
(2) The porous silicon used in Example 1 was replaced with high-purity silicon carbide raw material for normal growth and the surface was flattened.
(3) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 2/cm².

### Comparative example 2

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 500 µm, a porosity rate of 50% and a thickness of 10 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing, and multiple tests showed that the density of carbon inclusion defects was about 1.6/cm².

### Comparative example 3

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 180 µm, a porosity rate of 80% and a thickness of 10 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 1.4/cm².

### Comparative example 4

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 180 µm, a porosity rate of 50% and a thickness of 10 mm was selected and carefully cut into a cylinder with a diameter of D₂, D₂=D₁-d mm (d was about 0.3 mm). It was ensured that the pores were oriented towards the axis of the cylindrical porous silicon in direction, and angle of the pore channel and the axis in a direction perpendicular to the growth crucible was 80°.
(3) The porous silicon treated in step (2) was placed into the crucible loaded with silicon carbide raw material in step (1), and attached tightly to the raw material.

Results: The prepared silicon carbide crystal was annealed, rounded, cut, ground, and polished, and then subjected to microscopic analysis and testing. Multiple tests showed that the defect density of carbon inclusion was about 1.2/cm².

### Comparative example 5

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 180 µm, a porosity rate of 50% and a thickness of 10 mm was selected and carefully cut into a cylinder with a diameter of D₂, D₂=D₁-d mm (d was about 0.3 mm). It was ensured that the pores were in a direction perpendicular to the direction of the axis of the cylindrical porous silicon, the inclination angle of the pores was γ=150°, and the direction of the pores were arranged in a V shape.
(3) The porous silicon treated in step (2) was placed into the crucible loaded with silicon carbide raw material in step (1), and attached tightly to the raw material.

Results: The prepared silicon carbide crystal was annealed, rounded, cut, ground, and polished, and then subjected to microscopic analysis and testing. Multiple tests showed that the defect density of carbon inclusion was about 1.2/cm².

### Comparative example 6

(1) A graphite crucible was selected for growth with an inner diameter of D₁. The high-purity silicon carbide raw material used in normal growth was loaded and the surface was flattened.
(2) A porous silicon with a purity greater than 99.99%, a pore diameter of 50 µm, a porosity rate of 20% and a thickness of 10 mm was selected and carefully cut into a cylinder with a diameter of D₂, D₂=D₁-d mm (d was about 0.3 mm).
(3) The porous silicon treated in step (2) was placed into the crucible loaded with silicon carbide raw material in step (1), and attached tightly to the raw material.
(4) The normal process was adopted for the growth. After the crystal was taken out of the crucible, the obtained crystal was detected for defects such as inclusions, microtubes and dislocations.

Results: The prepared silicon carbide crystal was annealed, rounded, cut, ground, and polished, and then subjected to microscopic analysis and testing. Multiple tests showed that the defect density of carbon inclusion was about 1.6/cm².

The above are only preferred embodiments of the present disclosure. It should be noted that those of ordinary skill in the art can make several improvements and modifications without departing from the principles of the present disclosure. These improvements and modifications should also be considered as within the protection scope of the present disclosure.

## Claims

1. **A method** for growing a silicon carbide crystal comprising steps of:
A) putting silicon carbide raw material into a growth crucible,
B) placing porous silicon into the growth crucible, with lower surface of the porous silicon attached to upper surface of the silicon carbide raw material, and
C) performing growing to obtain a silicon carbide crystal.

2. The method according to claim 1, wherein the porous silicon has a purity of greater than 99.99%, a pore diameter of 100 to 300 µm, a porosity rate of 30% to 70%, and a thickness of 5 to 20 mm; and
the porous silicon has a size in horizontal direction smaller than the cross-sectional size of the growth crucible by d, wherein 0 < d ≤ 0.5 mm.

3. The method according to claim 1, wherein the porous silicon has a pore channel with a three-dimensional interlocking structure and the pore channel is in a direction parallel to an axis in a direction perpendicular to the growth crucible.

4. The method according to claim 3, wherein the upper surface of the silicon carbide raw material is a flat surface and the lower surface of the porous silicon is a flat surface.

5. The method according to claim 3, wherein the upper surface of the silicon carbide raw material is conical and the lower surface of the porous silicon is inwardly concaved into a conical shape with a size matching the conical shape formed by the upper surface of the silicon carbide raw material;
wherein an angle between the conical shape and the horizontal direction is θ, wherein 0 < θ≤ 30°.

6. The method according to claim 1, wherein the pore channel of the porous silicon is arranged inclinedly around the axis in a direction perpendicular to the growth crucible, and an angle between the pore channel and the axis in a direction perpendicular to the growth crucible is γ, wherein 0 < γ ≤ 60°, wherein an inclined direction of the pore channel extends from the axis in a direction perpendicular to the growth crucible toward an inner wall of the growth crucible from top to bottom.

7. The method according to claim 6, wherein the upper surface of the silicon carbide raw material is a flat surface and the lower surface of the porous silicon is a flat surface.

8. The method according to claim 6, wherein the upper surface of the silicon carbide raw material is conical and the lower surface of the porous silicon is inwardly concaved into a conical shape with a size matching the conical shape formed by the upper surface of the silicon carbide raw material;
wherein an angle between the conical shape and the horizontal direction is θ, wherein 0 < θ≤ 30°.

9. The method according to claim 1, wherein an inner side of the growth crucible is cylindrical and the porous silicon is cylindrical.

10. The method according to claim 1, wherein the growing is carried out at 2100°C to 2400°C for 100 to 200 h.
